# FASCICULE DE BREVET EUROPEEN

(11) **EP 2 381 471 B1**
(45) Date de publication et mention de la délivrance du brevet: **05.10.2016**
(21) Numéro de dépôt: 11163259.2
(22) Date de dépôt: 20.04.2011
(51) Int. Cl.: H01L 21/8247, H01L 21/28, H01L 29/792, H01L 29/423, H01L 27/115, H01L 29/66, H01L 21/336

(54) **Fabrication d'une mémoire a deux grilles independantes auto-alignées**
Herstellung eines Speichers mit zwei unabhängigen selbstausrichtenden Gates
Production of a memory unit with independent self-aligned gates

(30) Priorité: 22.04.2010 FR 1053076
(43) Date de publication de la demande: 26.10.2011
(73) Titulaire: Commissariat à l'Énergie Atomique et aux Énergies Alternatives, 75015 Paris (FR); Centre National de la Recherche Scientifique, 75016 Paris (FR)
(72) Inventeur: Molas, Gabriel, 38000, GRENOBLE (FR); Baron, Thierry, 38120, SAINT-EGREVE (FR)
(74) Mandataire: Ilgart, Jean-Christophe

(56) Documents cités:
- EP-A1- 2 088 618
- US-A- 5 948 470
- US-A1- 2009 111 226
- US-A1- 2009 111 229

## Description

### DOMAINE TECHNIQUE

La présente invention concerne le domaine de la microélectronique et en particulier celui des mémoires.

Elle concerne un procédé de réalisation d'un dispositif microélectronique doté de transistors avec des grilles accolées entre elles. Ce procédé s'applique notamment à la réalisation de dispositifs de mémoires non-volatiles.

L'invention apporte des améliorations en termes de précision du positionnement des grilles accolées, ce qui se traduit par des performances électriques améliorées des mémoires non-volatiles dotées de telles grilles.

### ART ANTÉRIEUR

Les dispositifs de mémoires effaçables susceptibles de conserver une information en l'absence d'alimentation sont appelés mémoires non-volatiles.

On recherche dans l'idéal à mettre en oeuvre une mémoire non volatile, qui combinerait les caractéristiques suivantes : possibilités d'écriture et d'effacement électrique, faible encombrement et faible coût par bit, accès aléatoire, temps d'écriture et de lecture courts, bonne endurance, mais aussi faible consommation et faible tension d'alimentation.

La mémoire Flash permet d'obtenir un bon compromis entre tous les critères précités.

Les mémoires Flash sont des mémoires non-volatiles dans lesquelles une cellule mémoire peut être programmée électriquement individuellement, alors qu'un grand nombre de cellules mémoires, appelé « bloc », « secteur », ou « page », peut être effacé électriquement en même temps.

Les mémoires Flash combinent à la fois des exigences de faible encombrement des mémoires EPROMs et de possibilité d'effacement électrique des mémoires EEPROMs.

La plupart des mémoires non-volatiles sont dotées d'une structure contenant un site de stockage de charge appelé grille flottante.

Des dispositifs mémoires non-volatiles de type MONOS (MONOS pour « Métal Oxyde Nitrure Oxyde Silicium ») sont apparus et ont remplacé la structure traditionnelle de grille flottante en polysilicium. Dans les mémoires de type MONOS, la charge est stockée dans une couche de piégeage de charge en nitrure de silicium.

Une structure de mémoire appelée « split-gate » qui comprend à la fois un transistor mémoire et un transistor de sélection est également apparue. Les mémoires de type « split-gate » sont généralement programmées par un mécanisme qui requiert la mise en oeuvre d'un transistor de sélection dont la grille est accolée à celle du transistor mémoire.

Une telle structure permet d'obtenir une vitesse de programmation améliorée et une consommation réduite.

Une des difficultés de mise en oeuvre de ces mémoires concerne la précision du positionnement des grilles les unes par rapport aux autres. Les grilles sont généralement réalisées par des photolithographies successives. Un mauvais contrôle des positions relatives l'une par rapport à l'autre des grilles accolées, se traduit par un mauvais contrôle des caractéristiques électriques du transistor mémoire, et donc des performances de la mémoire.

Lorsqu'on met en oeuvre une structure de mémoire appelée « split-gate » un contrôle précis de la position des grilles accolées est requis.

Le document US 7 130 223 divulgue un procédé de réalisation d'un dispositif de mémorisation à transistor doté d'une grille parallélépipédique accolée à une autre grille, ayant une forme arrondie, semblable à celle d'un espaceur.

La réalisation d'un dispositif doté d'une telle grille a profil arrondi pose des problèmes notamment de définition des contacts, de précision de la dimension de grille.

Le document US2009/111226 A1 divulgue un procédé de réalisation d'un dispositif microélectronique de mémoire non-volatile doté de transistors à grilles accolés.

Il se pose le problème de trouver un nouveau procédé de réalisation d'un dispositif de mémoire doté de transistors à grilles accolées, avec un positionnement précis des grilles et une définition précise des motifs de grille.

### EXPOSÉ DE L'INVENTION

L'invention concerne un procédé de réalisation d'un dispositif microélectronique de mémoire non-volatile doté de transistors à grilles accolées, le procédé comprenant les étapes de :
a) formation dans une couche à base d'un premier matériau de grille reposant sur un support, d'au moins un premier bloc de grille de transistor et d'au moins un bloc sacrificiel, ledit premier bloc et ledit bloc sacrificiel étant séparés par un espace donné,
b) combler ledit espace donné à l'aide d'un empilement comprenant une couche isolante et un deuxième matériau de grille, ledit deuxième matériau de grille dans ledit espace formant un autre bloc de grille séparé du premier bloc par ladite couche isolante,
c) suppression dudit bloc sacrificiel.

On peut réaliser ainsi une mémoire à deux grilles indépendantes aux dimensions contrôlées.

Le bloc de grille et le bloc sacrificiel sont réalisés lors de la même étape a), ce qui permet de contrôler la dimension de l'espace vide entre ces blocs, dans lequel un bloc d'une autre grille est formé à l'étape b).

Selon l'invention, le procédé comprend en outre, préalablement à l'étape a), des étapes de :
- formation d'une couche de masquage à base de copolymère dibloc au-dessus de la couche à base dudit premier matériau de grille,
- retrait sélectif dans la couche de masquage à base de polymère dibloc, de blocs à base d'un polymère formant ledit copolymère dibloc, de manière à conserver au moins un motif de masquage donné et au moins un autre motif de masquage donné séparé d'une distance donnée dudit motif donné, lesdits motifs de masquage étant à base d'un autre polymère formant ledit copolymère dibloc, le premier bloc et le bloc sacrificiel étant réalisés à l'étape a) par gravure de ladite couche dudit premier matériau de grille à travers ledit motif donné et ledit autre motif donné.

En employant un copolymère dibloc pour former des motifs de masquage à travers lesquels on va graver le premier matériau de grille, on peut contrôler précisément le positionnement dudit premier bloc de grille par rapport audit bloc sacrificiel formés dans ledit premier matériau de grille et ledit autre bloc de grille.

On contrôle ainsi de manière précise ledit espace donné, et par conséquent, le dimensionnement de la grille formée en comblant ledit espace donné.

On contrôle ainsi également de manière précise le positionnement de bloc(s) sacrificiel(s) formés dans le premier matériau de grille.

Un positionnement précis des bloc(s) sacrificiel(s) peut permettre, lors d'étape(s) ultérieure(s) du procédé, de retirer ces blocs par gravure à travers un masque tout en ayant une contrainte moindre sur le positionnement de ce masque.

Le copolymère dibloc permet également de réaliser des grilles de faible dimension, par exemple de l'ordre de 15 nm.

Le motif donné et ledit autre motif donné peuvent être de forme parallélépipédique.

Le copolymère dibloc peut être choisi parmi l'un des matériaux suivants : PS-b-PMMA, ou PS-b-PI du Ps-b-PB.

Selon une possibilité de mise en oeuvre, la couche isolante peut être formée d'un empilement de couches comprenant au moins une couche diélectrique et au moins une couche de stockage de charges.

L'empilement peut être par exemple un tri-couches formé :
- d'au moins une première couche de matériau diélectrique,
- d'au moins une couche de stockage de charges formée sur ladite première couche de matériau diélectrique,
- d'au moins une deuxième couche de matériau diélectrique formée sur ladite couche de stockage de charges.

L'étape b) peut comprendre des étapes de :
- dépôt conforme de ladite couche isolante sur lesdits blocs dudit premier matériau de grille,
- dépôt dudit deuxième matériau de grille de manière à remplir ledit espace donné.

Selon une possibilité de mise en oeuvre, le procédé peut comprendre, entre l'étape b) et l'étape c) :
- la formation d'au moins un masque recouvrant ledit premier bloc de grille et ledit autre bloc de grille, le masque étant formé de manière à, recouvrir une partie du bloc sacrificiel d'un côté du premier bloc de grille et, dépasser d'un autre côté du premier bloc d'une distance prévue inférieure à ladite distance donnée l₂.
- gravures successives à travers le masque, du deuxième matériau de grille, de la couche isolante, et éventuellement d'une couche de masque dur.

Le bloc sacrificiel peut alors être retiré à l'étape c) par gravure à travers ledit masque.

Avec un tel masque, la tolérance de désalignement est plus importante que dans les procédé suivant l'art antérieur. Cette tolérance dépend de la taille des grilles que l'on souhaite former.

Selon une possibilité de mise en oeuvre du procédé, la couche à base du premier matériau de grille peut reposer sur une couche de diélectrique de grille reposant elle même sur le support.

La couche de copolymère dibloc peut être formée sur une couche de masque dur reposant sur la couche à base du premier matériau de grille, la gravure à l'étape a) étant réalisée à travers le masque dur, le procédé comprenant en outre entre l'étape a) et l'étape b), le retrait de la couche de diélectrique de grille entre le premier bloc et ledit bloc sacrificiel, par gravure à travers ledit masque dur.

La couche de masque dur peut ainsi servir à la fois de protection des blocs de premier matériau de grille à l'étape a) et de masque de gravure.

Le procédé peut comprendre en outre, après l'étape c), les étapes de :
- retrait dudit masque,
- retrait partiel de la couche isolante, la couche isolante étant conservée entre ledit premier bloc et ledit autre bloc de grille et sous le dit autre bloc de grille.

Selon une possibilité, l'étape a) peut comprendre la formation dans ladite couche à base dudit premier matériau de grille reposant sur ledit support, d'au moins un deuxième bloc de grille de transistor, ledit deuxième bloc et ledit bloc sacrificiel étant séparés par un autre espace donné, ledit bloc sacrificiel étant situé entre ledit premier bloc et ledit deuxième bloc de grille. Dans ce cas, l'étape b) peut comprendre la formation dans ledit autre espace donné dudit empilement comprenant ladite couche isolante et ledit deuxième matériau de grille, ledit matériau de grille situé dans ledit autre espace formant un bloc de grille, accolé audit deuxième bloc et séparé dudit deuxième bloc par ladite couche isolante.

Selon une possibilité de mise en oeuvre du procédé dans lequel ledit autre bloc de grille accolé au premier bloc de grille est un bloc de grille d'un premier transistor de mémorisation, ledit bloc de grille accolé au deuxième bloc de grille est un bloc de grille d'un deuxième transistor de mémorisation et est juxtaposé audit autre bloc de grille, le procédé comprenant en outre : la formation d'une zone de contact commune entre le premier transistor de mémorisation et ledit deuxième transistor de mémorisation.

Un dispositif tel que par exemple une cellule de mémoire flash NOR dans lequel une ligne de source commune aux sources de deux transistors mémoire adjacents peut être ainsi réalisé.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1P illustrent un premier exemple de procédé suivant l'invention, de réalisation d'un dispositif microélectronique de mémoire non-volatile à transistors dotés de grilles accolées entre elles,
- les figures 2A-2B illustrent une variante de réalisation dans laquelle plusieurs couples de transistors à grilles accolées sont réalisés en même temps,
- les figures 3A-3B illustrent une variante de l'exemple de procédé dans laquelle on forme plusieurs couples de transistors à grilles accolées, chaque couple de transistors comprenant un transistor mémoire, les couples étant agencés de sorte que leurs transistors mémoires sont agencés et peuvent être mis à un potentiel de source commun,
- les figures 4A-4C illustrent une variante de réalisation de motifs de masquage, mise en oeuvre au cours d'un procédé suivant l'invention,
- les figures 5A-5E illustrent un autre exemple de procédé suivant l'invention, qui diffère du premier exemple notamment de par l'ordre dans lequel on réalise les grilles des transistors.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

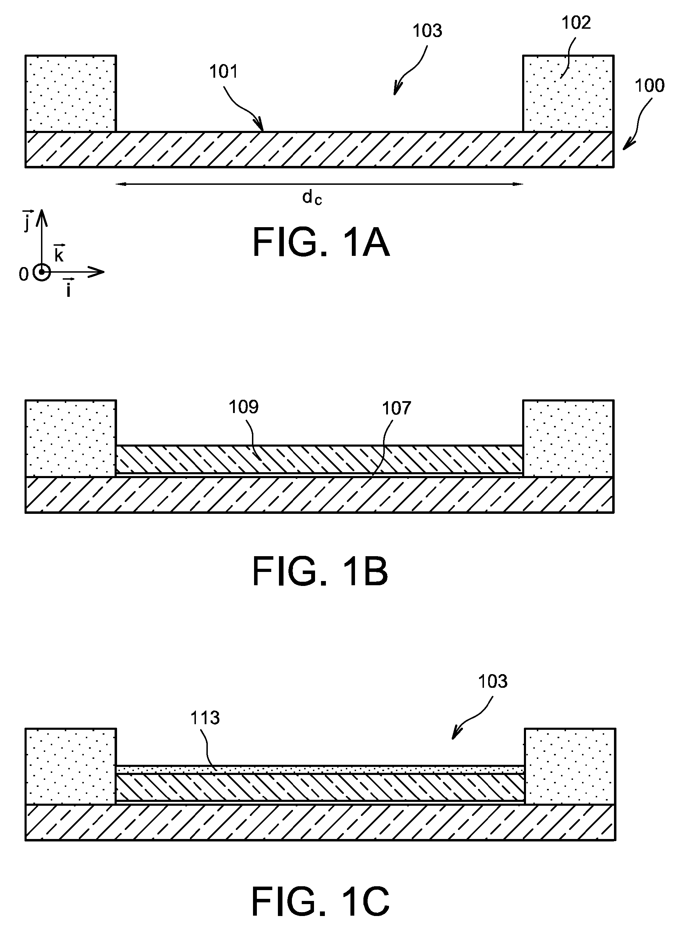

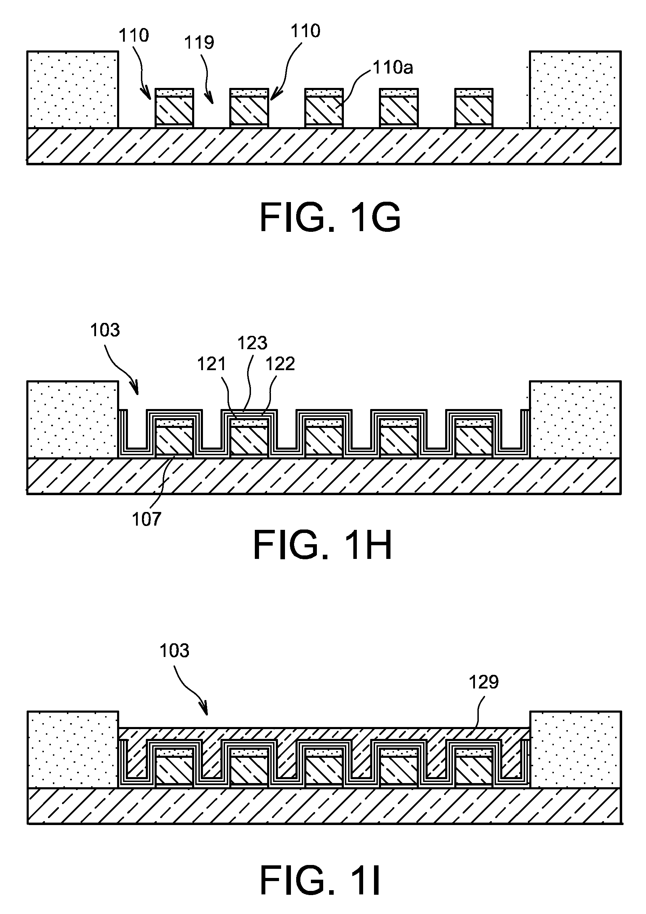

Un exemple de procédé de réalisation suivant l'invention, d'un dispositif microélectronique à transistors dont les grilles accolées, va à présent être donné en liaison avec les figures 1A-1P. Le dispositif microélectronique peut être une cellule de mémoire non-volatile, telle que par exemple une mémoire flash.

Sur un support 100, on réalise tout d'abord une cavité 103 dans une couche isolante 102 reposant sur le support 100. La cavité 103 peut avoir, par exemple, une forme rectangulaire et peut être réalisée, par exemple, à l'aide d'un procédé communément appelé de « Shallow Trench Isolation » (en français : « tranchée de faible profondeur »). La couche isolante 102 peut être par exemple à base de SiO₂. La cavité 103 peut être réalisée avec une dimension critique dc (mesurée dans une direction parallèle au support 100 et au vecteur *̅i̅*̅ d'un repère orthogonal [O*;i̅;j̅;k̅*] défini sur la figure 1A) qui peut être par exemple de l'ordre de 1 µm. Par « dimension critique », on entend la plus petite dimension d'un motif réalisé dans une couche ou un empilement de couches hormis sa hauteur ou son épaisseur. La cavité 103 est formée en regard d'une zone semi-conductrice 101 dans laquelle une ou plusieurs zones actives de transistors sont destinées à être réalisées (figure 1A).

Ensuite (figure 1B), on forme un empilement de grille en vue de réaliser une ou plusieurs grilles de transistor(s) d'un premier type, par exemple de transistor(s) de sélection ou d'accès de la cellule mémoire. L'empilement de grille comprend une couche de diélectrique 107 de grille, qui peut être réalisée par exemple par oxydation thermique de la zone semi-conductrice 101. La couche de diélectrique 107 de grille peut avoir une épaisseur par exemple de l'ordre de 5 nanomètres. L'empilement de grille comprend également une couche d'un matériau 109 de grille sur la couche de diélectrique 107, par exemple une couche de polysilicium, qui peut être dopée, selon un dopage de type N. La couche de matériau 109 de grille peut avoir une épaisseur par exemple de l'ordre de 100 nanomètres (figure 1B).

Puis (figure 1C), on forme une couche 113 de masque dur, par exemple à base de SiO₂, ou de HfO2_{,} ou de Al₂O₃, sur la couche de matériau 109 de grille.

La couche 113 de masque dur pourra servir de protection de la couche de matériau 109 de grille lors d'une gravure ultérieure de cette dernière.

Une étape de préparation de la surface de la couche 113 de masque dur de manière à créer des sites OH sur cette dernière peut être réalisée, par exemple par traitement à l'aide de HF lorsque la couche 113 de masque dur est à base de SiO₂.

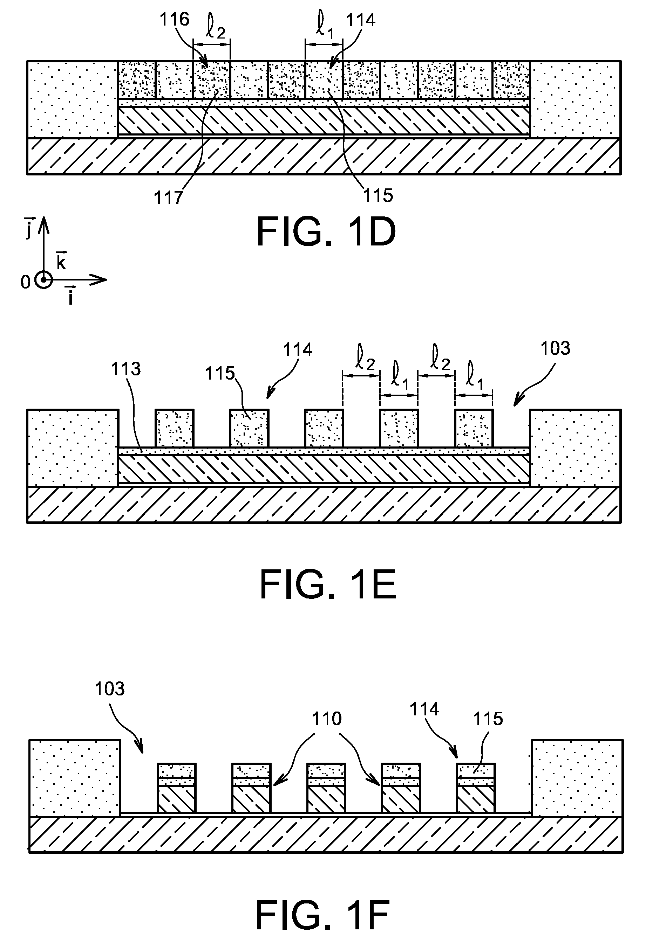

Ensuite, on réalise dans la cavité 103, une couche de masquage comprenant une pluralité de blocs 114 de dimension critique l₁ à base d'un premier polymère 115 et une pluralité de blocs 116 de dimension critique l₂ à base d'un autre polymère 117 (les dimensions critiques l₁, l₂ respectives étant mesurées dans une direction parallèle au vecteur *̅k̅*̅ d'un repère orthogonal [O*;i̅;j̅;k̅*] défini sur la figure 1D). Les dimensions l₁, l₂ des blocs 114 et 116 sont prévues en fonction des dimensions avec lesquelles on souhaite former les grilles du dispositif mémoire, et peuvent être égales à celles prévues, respectivement, pour au moins une première grille, et au moins une deuxième grille, du dispositif mémoire. Les dimensions l₁, l₂, peuvent être comprises par exemple entre 15 nanomètres et 40 nanomètres.

La couche de masquage peut être à base d'un matériau co-polymère à blocs et en particulier un matériau co-polymère dibloc, est utilisé. Un matériau copolymère dibloc est un matériau contenant une association de deux polymères 115 et 117 de natures chimiques différentes liés entre eux, et dont la répartition s'effectue selon une structure périodique régulière.

On utilise cette répartition périodique régulière pour former des motifs d'un masquage ayant une répartition régulière.

Le traitement de surface de la couche 113 de masque dur qui a été réalisé précédemment peut permettre de favoriser l'organisation des blocs de copolymères les uns par rapport aux autres.

Selon une possibilité de mise en oeuvre, les blocs 114, 116 peuvent être réalisés de manière à avoir une forme parallélépipédique et être parallèles entre eux.

Pour obtenir des blocs parallélépipédiques, on peut contrôler la composition du copolymère dibloc : par exemple de sorte qu'il est constitué de l'ordre de 50% de bloc polymère 115 et de l'ordre de 50% de bloc polymère 117, ce qui conduit à une organisation du copolymère en lamelles parallélépipédiques comme illustré sur la figure 1D.

Le matériau copolymère dibloc peut être par exemple du PS-b-PMMA (polystyrène-b-poly(méthyle méthacrylate) ou du PS-b-PI (polystyrène-b-polyisoprène) ou du Ps-b-PB (polystyrène-b-polybutadiène).

Dans le cas où le matériau copolymère dibloc est du PS-b-PMMA, ce dernier peut avoir une fraction volumique de l'ordre de 0.3, une masse molaire en poids de l'ordre de 67100 g.mol⁻¹ et un indice de polymolécularité de 1.09. Les chaînes de polymère dibloc peuvent être diluées dans une solution de toluène de sorte à obtenir une concentration par exemple de l'ordre de 1 % en poids, puis peuvent être déposées à la tournette avec une vitesse par exemple de l'ordre de 3000 tours/minute, une accélération de 1000 (tours/minute).s⁻¹ et une durée par exemple de l'ordre de 30 s. Ainsi, on peut obtenir une couche homogène d'épaisseur de PS-b-PMMA par exemple de l'ordre de 35 nm. La couche obtenue est ensuite portée, sous vide, à une température par exemple de l'ordre de 170°C pendant une durée par exemple de l'ordre de 48 heures.

L'orientation des blocs de PMMA au sein de la couche de copolymère est régie par des effets d'interaction de surface entre les différents blocs et la couche isolante, en particulier lorsqu'elle est à base d'oxyde de silicium.

On peut neutraliser cette interaction par exemple par dépôt d'un copolymère aléatoire PS-PMMA, de manière à former une alternance de blocs parallélépipédiques comme représenté sur la figure 1D.

Ensuite, on effectue un retrait de portions de la couche de masquage de manière à conserver certains motifs de masquage.

Dans le cas, par exemple, où le co-polymère est du PS-PMMA, le matériau retiré est du PMMA. Pour cela, un retrait des blocs 116 à base du deuxième polymère 117, sélectif vis-à-vis du premier polymère 115 peut être mis en oeuvre (figure 1E).

Selon un autre exemple, dans le cas d'un système PS-b-PI, ce retrait sélectif peut être effectué par utilisation d'un traitement à l'aide d'ozone, permettant de dégrader sélectivement les blocs de polyisoprène (PI) par rapport aux blocs de polybutadiène (PB).

Dans le cas d'un système PS-b-PMMA, il est également possible de graver sélectivement des blocs de PS par rapport à des blocs de PMMA. Pour cela, un procédé de gravure plasma en deux étapes utilisant un plasma CF₄ puis un plasma O₂, peut être utilisé.

Dans le cas où le co-polymère est du PS-b-PMMA, il est également possible de procéder au retrait sélectif de blocs de PMMA dans un système co-polymère dibloc de type PS-b-PMMA par utilisation de radiation UV. Ces radiations UV créent une scission préférentielle des chaînes de PMMA. Le retrait de blocs de PMMA peut être réalisé par exemple en exposant la couche de co-polymère à un éclairage ultraviolet HgXe par exemple à une dose de l'ordre de 1,2 J.cm⁻² pendant une durée par exemple de l'ordre de 15 minutes, plongé dans un bain d'acide acétique durant 10 minutes, puis rincé à l'eau dé-ionisée. Dans le but de retirer des éléments résiduels des blocs 116 de polymère 117, on peut effectuer une gravure sous un plasma, en particulier un plasma à couplage inductif (ICP), par exemple à 4,2 mTorr, et à base de Ar à 50 sccm (sccm pour « standard cubic centimeters per minute ») et O₂ à 5 sccm, avec une puissance source qui peut être par exemple de l'ordre de 70 W, l'exposition pouvant durer par exemple de l'ordre de 15 secondes.

A l'issue de ce retrait sélectif, on obtient des blocs 114 de polymère 115 parallépipédiques régulièrement répartis sur l'empilement de grille (figure 1E).

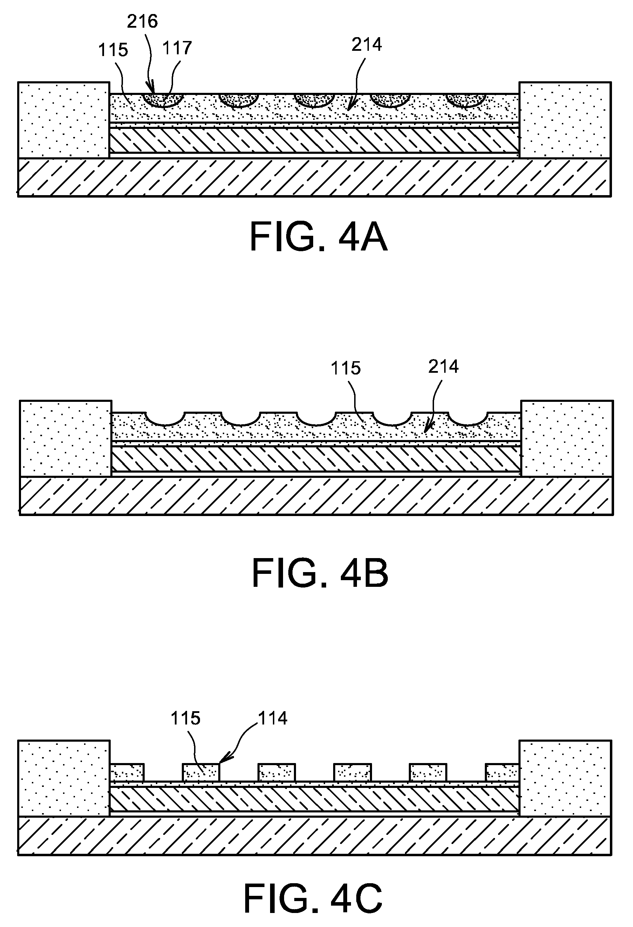

Selon une variante (figures 4A-4C) de réalisation, il est également possible d'utiliser un copolymère asymétrique, dont la proportion en polymère 115 et en polymère 117 est différente de 50/50.

Avec un tel copolymère, on peut former, dans une couche 214 à base du premier polymère 115, une pluralité de blocs 216, à base du deuxième polymère 117, qui sont cylindriques, ou ont une section circulaire ou ovale, et s'étendent parallèlement au substrat (figure 4A). Dans le cas d'un copolymère PS-PMMA, on peut obtenir un tel agencement avec, par exemple, 30% de PMMA et 70% de PS.

On peut ensuite éliminer les blocs 216 de PMMA, en combinant des traitements à base d'acide acétique et de gravure plasma Ar O₂ (figure 4B).

Un amincissement de la couche 214 de PS restant, par exemple par gravure anisotrope à l'aide d'Ar O₂, est effectué de manière à obtenir des blocs 114 de polymère 115 parallélépipédiques régulièrement répartis sur l'empilement de grille (figure 4C).

On effectue ensuite une gravure du matériau 109 de grille, en se servant des blocs 114 ou 214 de polymère 115 comme masque de gravure.

Dans le cas d'une grille en polysilicium, Cette gravure peut être réalisée par exemple par gravure sèche du polysilicium en utilisant les blocs 114 de polymère 115 comme masque de gravure et le diélectrique 107 de grille comme couche d'arrêt de gravure. Ainsi, on grave la couche de matériau 109 de grille, de manière à former des blocs 110 de grille pour transistors d'un premier type, par exemple pour des grilles de transistors de sélection ou d'accès de la cellule mémoire (figure 1F).

Pendant cette gravure, les blocs 114 de polymère 115 peuvent être partiellement consommés (figure 1F).

Selon une variante (non représentée), cette gravure peut être réalisée de sorte qu'à la fin de cette dernière, les blocs 114 de polymère 115 sont entièrement consommés. Le masque dur 113 permet alors de protéger les blocs 110 à base du premier matériau 109 de grille pendant la gravure.

Dans un cas, où, à l'issue de la gravure, les blocs 114 ne sont pas entièrement consommés, on effectue un retrait du polymère 115, par exemple à l'aide d'un plasma O₂.

On obtient, une fois la gravure réalisée, une pluralité de blocs 110 distincts à base du premier matériau 109 de grille, séparés entre eux par un espace 119 vide, et répartis selon un pas régulier sur la couche diélectrique 107. Parmi ces blocs 110 distincts à base du premier matériau 109 de grille, au moins un bloc 110a est destiné à former une grille de transistor, tandis qu'un ou plusieurs blocs sont destinés à être supprimés ultérieurement.

La couche de diélectrique 107 peut être ensuite gravée à travers le masque dur de manière à n'être conservée que sous les blocs 110 de grille (figure 1G).

On réalise ensuite une ou plusieurs grilles de transistors d'un deuxième type, par exemple de transistors de mémorisation.

Pour cela, on forme tout d'abord dans la cavité 103, un empilement isolant tri-couches 121, 122, 123 tel qu'un empilement ONO.

L'empilement isolant tri-couches 121, 122, 123 peut être réalisé par dépôt conforme de manière à recouvrir les blocs 110.

Pour cela, une couche de matériau diélectrique 121, par exemple à base d'oxyde de silicium, et d'épaisseur par exemple de l'ordre de 6 nanomètres, est tout d'abord déposée. Ensuite, une couche de piégeage de charges, qui peut être à base de matériau diélectrique 122, par exemple tel que du nitrure de silicium, et d'épaisseur par exemple de l'ordre de 6 nanomètres, est formée.

Puis, une autre couche d'oxyde de silicium 123, par exemple de l'ordre de 8 nanomètres d'épaisseur, est réalisée.

Du fait du retrait de la couche diélectrique 107 de grille entre les blocs 110 de grille, on peut former un diélectrique de grille spécifique et de bonne qualité pour les deuxièmes grilles.

Ensuite, on dépose un matériau 129 de grille dans la cavité 103. Le matériau 129 de grille peut être déposé selon un dépôt non-conforme, de manière à combler les espaces 115 séparant les blocs 110 de grille. Le matériau 129 peut être déposé de manière à recouvrir les blocs 110 de grille recouverts par l'empilement ONO 121-122-123. Le matériau 129 peut être par exemple du polysilicium, en particulier du polysilicium dopé avec un dopant de type N (figure 1I).

Puis, on effectue un retrait partiel du matériau 129 de grille par gravure anisotrope.

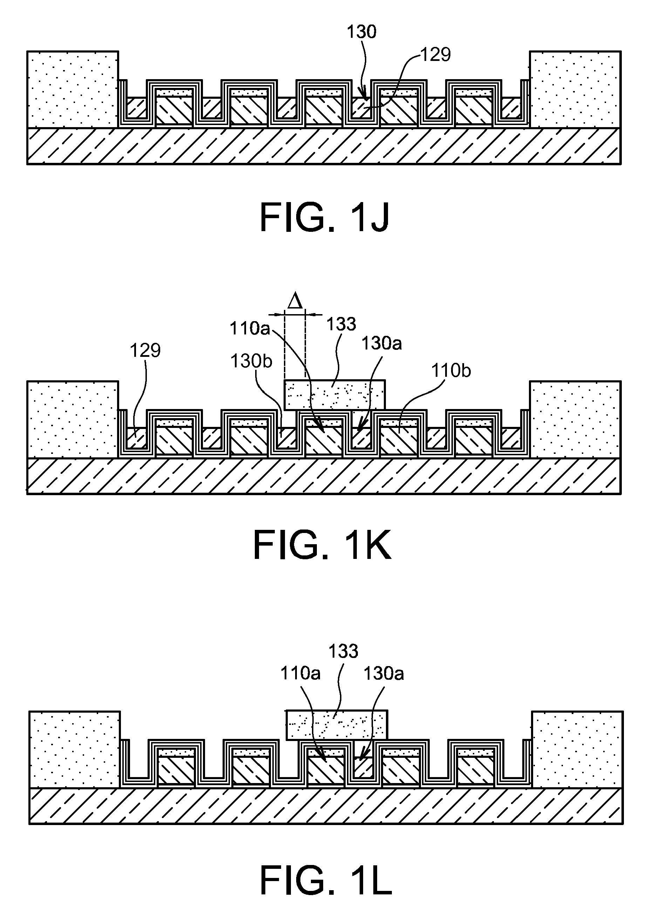

Cette gravure peut être une gravure sèche, réalisée par exemple à l'aide de HBr-Cl par exemple, ou une gravure humide, par exemple à l'aide de TMAH (en français Hydroxyde de Tetramethylammonium). Le retrait est effectué de manière à conserver des blocs 130 de matériau 129 de grille de part et d'autre des blocs 110 de grilles de transistor(s) de sélection. Le retrait peut être réalisé de sorte que les blocs 130 de matériau 129 de grille ont une hauteur égale ou sensiblement égale ou proche de celle des blocs 110 (figure 1J).

Ensuite, on forme un masque 133 par exemple à base de résine, qui recouvre au moins un premier bloc donné 110a parmi les blocs 110 de grille des transistors de sélection, et au moins un autre bloc 130a parmi les blocs 130 de grille des transistors de mémorisation, l'autre bloc 130a étant accolé au premier bloc donné et séparé de ce dernier par l'empilement ONO. Le masque 133 de résine peut être réalisé par photolithographie. Dans cet exemple de réalisation, un alignement exact du masque 133 de résine avec le premier bloc 110a et le deuxième bloc 130a n'est pas indispensable. Ainsi, le masque 133 peut être éventuellement formé de manière à dépasser partiellement à l'aplomb d'un autre bloc parmi les blocs 130, et peut également reposer sur au moins un autre bloc donné parmi lesdits blocs 110. Du fait du positionnement précis de l'ensemble des blocs 110 et 130, la contrainte de positionnement du masque 133 est moindre. La longueur de dépassement Δ à l'aplomb dudit autre bloc parmi les blocs 130 peut être prévue inférieure à la dimension critique l₂ (figure 1K).

Le procédé de photolithographie pour réaliser le masque peut être prévu avec une tolérance de désalignement plus importante que dans les procédé suivant l'art antérieur, et qui dépend de la taille des grilles que l'on souhaite former.

Ensuite, on effectue un retrait du matériau 129 de grille du dispositif mémoire, en dehors des zones protégées par le masque 133 de résine, en utilisant par exemple du TMAH. L'arrêt de la gravure se fait sur la couche supérieure de l'empilement de couches 121-122-123 (figure 1L).

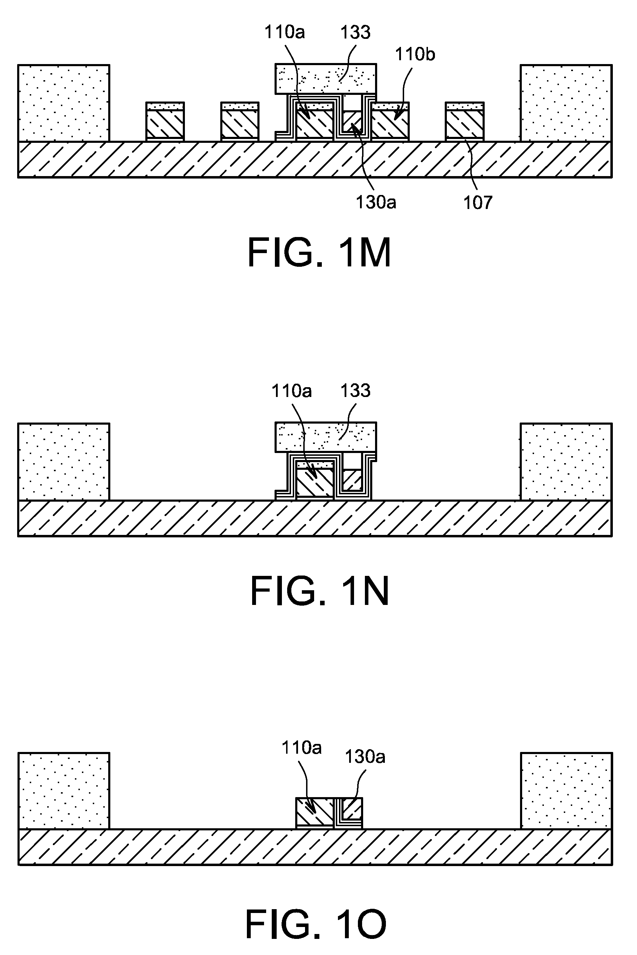

Puis, on effectue un retrait de l'empilement de couches 121-122-123, en dehors des zones protégées par le masque 133 de résine (figure 1M). Le retrait de l'empilement de couches 121-122-123 peut être réalisé tout d'abord par une gravure par exemple à l'aide de HF pour retirer la couche diélectrique 121, lorsque cette dernière est à base de SiO₂. Ensuite, pour retirer la couche 122, on peut effectuer une gravure avec de l'acide H₃PO₄ lorsque cette dernière est à base de Si₃N₄. Puis, le retrait de la couche 123 peut être réalisé par une gravure par exemple à l'aide de HF, lorsque cette dernière est à base de SiO₂. Le retrait de la couche 123 peut être effectué de manière à conserver au moins une partie de la couche de diélectrique 107 de grille sur la zone semi-conductrice 101.

A l'issue de ce retrait le premier bloc 110a et le deuxième bloc 130a sont recouverts sur le dessus et sur leurs flancs latéraux, par l'empilement ONO 121, 122, 123.

Ensuite, on effectue un retrait de blocs 110b à base du premier matériau 109 de grille, du diélectrique 107, en dehors des zones protégées par le masque de résine 133. Pour cela, une gravure chimique sélective et isotrope à base de TMAH peut être utilisée pour graver le bloc de grille 110b qui n'est ni entièrement recouvert par le masquage 133 ni entièrement recouvert par l'empilement de couches 121-122-123, la zone semi-conductrice 101 étant protégée par la couche diélectrique 107. Le masque dur 113 est également retiré lors de cette gravure (figure 1N).

Ensuite, un retrait du masque 133 de résine est effectué.

Puis, on effectue un retrait de l'empilement de couches 121, 122, 123, sur les blocs de grille 110a, 130a qui étaient protégés par le masque 133 de résine.

Par exemple, pour un empilement ONO c'est à dire « Oxyde », « Nitrure », « Oxyde », on peut utiliser de l'acide HF pour enlever la couche 123 d'oxyde de silicium, puis de l'acide H₃PO₄ pour enlever la couche 122 de nitrure de silicium, puis de l'acide HF pour enlever la couche 121 d'oxyde de silicium (figure 1O).

Un retrait de la couche de masque dur 113 sur le premier bloc 110a est également réalisé. Dans le cas où la couche de masque dur 113 est à base de Al₂O₃ ou HfO₂, on peut utiliser du BCl₃-Cl pour retirer le masque dur). Lorsque la couche de masque dur 113 est formée à base de SiO₂, ce retrait peut être par exemple réalisé en même temps que la couche d'oxyde de silicium 121.

Puis, on peut effectuer un dopage des zones actives des transistors, par exemple par implantation, puis de réalisation d'espaceurs 151, 152, de part et d'autre des bloc 110a, 130a de grille accolés.

Une autre étape d'implantation de la zone active est ensuite réalisée.

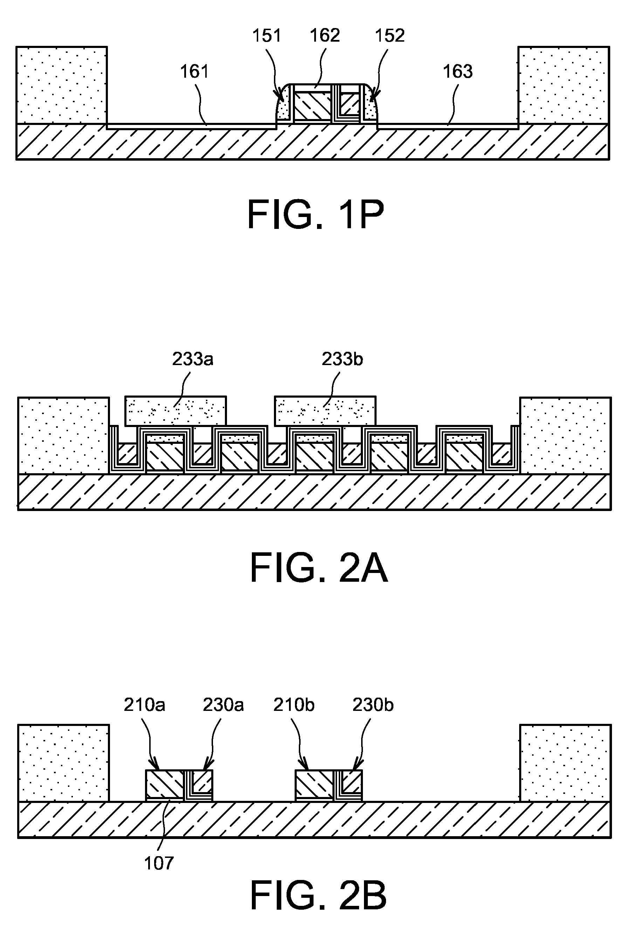

Une siliciuration des grilles et des zones actives peut être ensuite effectuée, afin de former des zones 161, 162, 163 de prise de contact, des zones actives et de la grille (figure 1P).

On peut ensuite réaliser un ou plusieurs niveaux d'interconnexions des transistors.

Les figures 2A-2B illustrent une variante de réalisation dans laquelle, après l'étape décrite précédemment en liaison avec la figure 1J, on forme plusieurs masques 233a, 223b de résine du type du masque 133.

Les masques 233a, 223b peuvent être séparés d'une distance égale à la somme de la dimension critique l₁ d'un bloc 116 de polymère 117 et de la dimension critique l₂ d'un autre bloc 114 de polymère 115. Le masque 233a, repose sur un bloc 210a de grille formé à base du premier matériau 109 de grille et sur un autre bloc à base du premier matériau 109 de grille, qui est destiné à être supprimé. Le masque 233b, repose sur un bloc 210b de grille formé à base du premier matériau 109 de grille et sur un autre bloc à base du premier matériau 109 de grille, qui est destiné à être supprimé.

On effectue ensuite des gravures successives à travers ces masques 233a, 233b de manière à retirer le matériau 129 de grille, l'empilement de couches 121-122-123, et le matériau 109 de grille en dehors des masques.

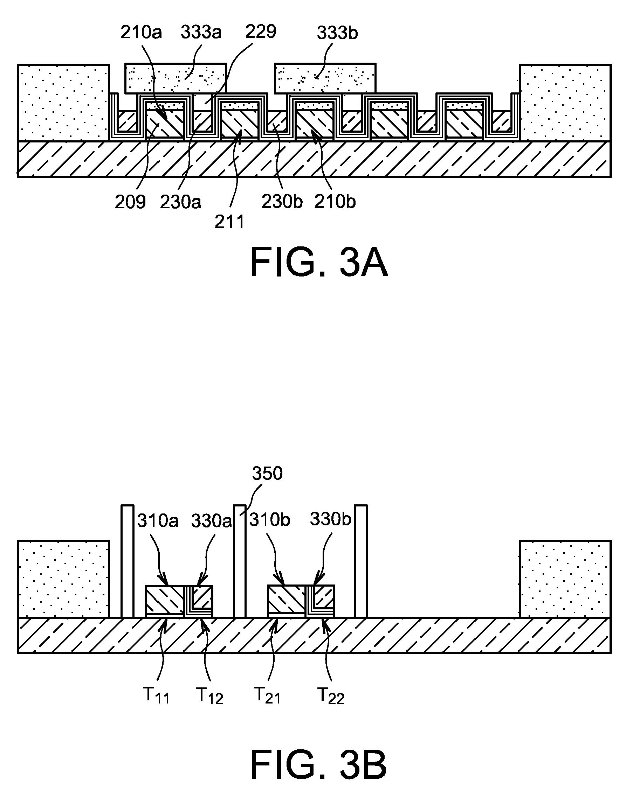

Une autre variante du procédé précédemment décrit est donné sur les figures 3A-3B. Pour cette variante, un premier masque 333a, est formé sur un premier bloc 210a de matériau 209 et au-dessus d'un deuxième bloc 230a de matériau 229 de grille. Le masque 333a repose également sur une partie d'un bloc sacrificiel 211 de matériau 209 de grille. Un deuxième masque 333b, est formé sur un bloc 210b de matériau 209 et au-dessus d'un bloc 230b de matériau 229 de grille. Le masque 333a repose également sur une partie du bloc sacrificiel 211, qui sépare les blocs 230a et 230b à base du matériau 229 de grille.

On effectue ensuite des gravures successives à travers ces masques 333a, 333b de manière à retirer le matériau 129 de grille, l'empilement de couches 121-122-123, et le matériau 109 de grille en dehors des masques.

On peut réaliser ainsi un couple de transistors T₁₁ et T₁₂, à grilles 310a et 330a accolées, qui partagent une électrode commune avec un autre couple de transistors T₂₁ et T₂₂ à grilles 310c et 330c accolées. Chaque couple de transistors comprend un transistor d'accès T₁₁ ou T₂₂ et un transistor de mémorisation T₁₂ et T₂₁, les transistors de mémorisation étant formés de manière à être adjacents et à partager un contact 350 commun et une zone de source commune à laquelle ce contact 350 est connecté.

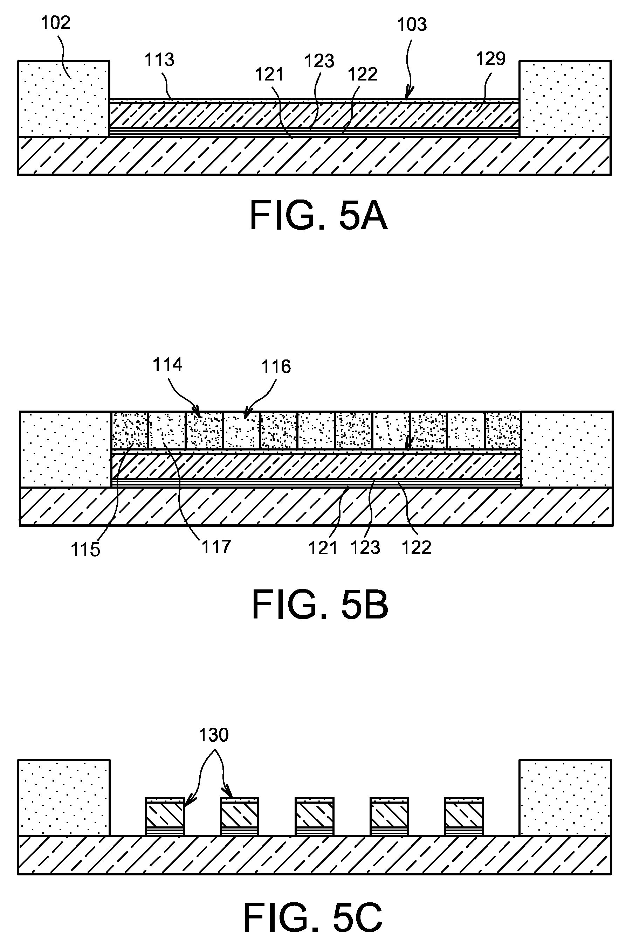

Selon une variante du procédé de réalisation décrit en liaison avec les figures (figures 5A-5D), on peut intervertir l'ordre de réalisation des blocs de grille 110a et 130a.

Ainsi, on réalise tout d'abord dans la cavité 103, l'empilement tri-couches 121, 122, 123, puis le dépôt du matériau 129 de grille (figure 5A).

Ensuite, on forme le masque dur 113, puis la couche de co-polymère dibloc avec une alternance de blocs 114 de polymère 115 et de blocs 116 de polymère 117 (figure 5B).

On réalise des blocs 130a de grille régulièrement répartis par gravure du matériau 129 de grille et du tri-couches 121-122-123 à travers des motifs de polymère 115.

Puis, on retire ces motifs de polymère 115 (figure 5C)

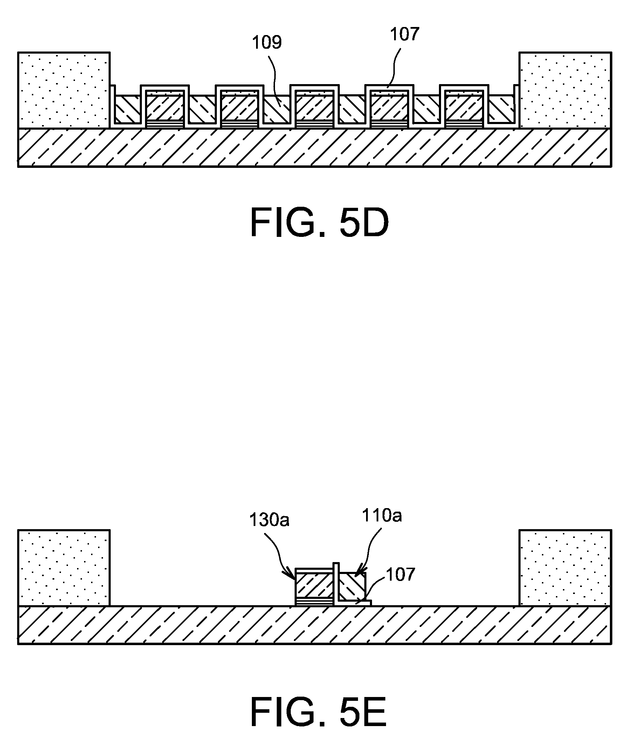

On réalise ensuite un empilement de grille formé du diélectrique 107 et du matériau 109 de grille, entre les blocs 130a régulièrement répartis (figure 5D).

On effectue ensuite, une gravure à travers un masquage de résine afin de réaliser le bloc de grille 110a accolé au bloc 130a, et retirer les blocs de grille sacrificiels (figure 5E).

## Revendications

1. Procédé de réalisation d'un dispositif microélectronique de mémoire non-volatile doté de transistors à grilles accolées, le procédé comprenant les étapes de ;
- formation d'une couche de copolymère dibloc au-dessus d'une couche à base d'un premier matériau (109) de grille reposant sur un support,
- retrait sélectif dans la couche de polymère dibloc, de blocs (116) à base d'un polymère (117) dudit copolymère, de manière à conserver des motifs (114) séparés entre eux d'une distance donnée (l₂), lesdits motifs (114) étant à base d'un autre polymère (115) dudit copolymère, puis des étapes de :
a) formation, par gravure de ladite couche dudit premier matériau de grille à travers lesdits motifs (114), d'au moins un premier bloc (110a) de grille de transistor et d'au moins un bloc sacrificiel (110b), ledit premier bloc (110a) et ledit bloc sacrificiel (110b) étant séparés par un espace donné,
b) formation dans ledit espace donné d'au moins une couche isolante (121-122-123) et d'un deuxième matériau (129) de grille, ledit deuxième matériau de grille dans ledit espace formant un autre bloc (130a) de grille séparé du premier bloc (110a) par ladite couche isolante, puis,
- formation d'un masque (133) recouvrant ledit premier bloc (110a) de grille et une partie du bloc (110b) sacrificiel, le masque étant réalisé d'un côté du premier bloc (110a) de manière à recouvrir ledit autre bloc (130a) de grille, et d'un autre côté du premier bloc (110a) de manière à dépasser du premier bloc (110a), en particulier d'une longueur de dépassement inférieure à ladite distance donnée (l₂),
- gravures successives à travers le masque (133), du deuxième matériau (129) de grille, de la couche isolante,
c) suppression du bloc sacrificiel (110c) par gravure à travers ledit masque (133).

2. Procédé selon la revendication 1, dans lequel la couche à base du premier matériau (109) de grille repose sur une couche (107) de diélectrique de grille reposant sur le support, à couche (113) de copolymère dibloc est formée sur une couche de masque dur (113) reposant sur la couche à base du premier matériau (109) de grille, la gravure à l'étape a) étant réalisée à travers le masque dur, le procédé comprenant en outre entre l'étape a) et l'étape b), le retrait de la couche (107) de diélectrique de grille entre le premier bloc et ledit bloc sacrificiel, par gravure à travers ledit masque dur.

3. Procédé selon l'une des revendications 1 ou 2 : les motifs étant parallélépipédiques.

4. Procédé selon l'une des revendications 1 à 3, le copolymère dibloc étant choisi parmi l'un des matériaux suivants : PS-b-PMMA, PS-b-PI.

5. Procédé selon l'une des revendications 1 à 4, dans lequel ladite couche isolante (121-122-123) est formée d'un empilement comprenant :
- au moins une première couche (121) de matériau diélectrique,
- au moins une couche (122) de stockage de charges formée sur ladite première couche de matériau diélectrique,
- au moins une deuxième couche (123) de matériau diélectrique formée sur ladite couche de stockage de charges.

6. Procédé selon la revendication 5, dans lequel l'étape b) comprend des étapes de :
- dépôt conforme de ladite couche isolante (121-122-123) sur lesdits blocs (110a, 110b) dudit premier matériau de grille,
- dépôt dudit deuxième matériau (129) de grille de manière à remplir ledit espace donné.

7. Procédé selon la revendication 6, comprenant en outre, après l'étape c), les étapes de :
- retrait du masque (133),
- retrait partiel de la couche isolante (121-122-123), la couche isolante étant conservée entre ledit premier bloc (110a) et ledit autre bloc (130a) de grille et sous le dit autre bloc (130a) de grille.

8. Procédé selon l'une des revendications 1 à 7, dans lequel le dit support comprend une zone semi-conductrice (101) dans laquelle les canaux desdits transistors sont prévus, la zone semi-conductrice étant recouverte d'une zone de diélectrique (107) de grille, puis de ladite couche dudit premier matériau (109) de grille.

9. Procédé selon la revendication 8, dans lequel la zone de diélectrique (107) de grille, ladite couche dudit premier matériau (109) de grille sont formées dans une cavité (103) réalisée dans une couche isolante (102) reposant sur le support.

10. Procédé selon l'une des revendications 1 à 9, l'étape a) comprenant la formation dans ladite couche à base dudit premier matériau (109) de grille reposant sur ledit support, d'au moins un deuxième bloc (110c) de grille de transistor, ledit deuxième bloc (110c) et ledit bloc sacrificiel (110b) étant séparés par un autre espace donné, ledit bloc sacrificiel (110b) étant situé entre ledit premier bloc (110a) et ledit deuxième bloc (110c) de grille,
l'étape b) comprenant la formation dans ledit autre espace donné dudit empilement comprenant ladite couche isolante (121-122-123) et ledit deuxième matériau (129) de grille, ledit matériau de grille situé dans ledit autre espace formant un bloc (130c) de grille, accolé audit deuxième bloc (110c) et séparé dudit deuxième bloc (110c) par ladite couche isolante.

11. Procédé selon la revendication 10, dans lequel ledit autre bloc (130a) de grille accolé au premier bloc (110a) de grille est un bloc de grille d'un premier transistor de mémorisation, ledit bloc (130c) de grille accolé au deuxième bloc (110c) de grille est un bloc de grille d'un deuxième transistor de mémorisation et est juxtaposé audit autre bloc (130a) de grille, le procédé comprenant en outre la formation d'une zone de contact commune entre le premier transistor de mémorisation et ledit deuxième transistor de mémorisation.

## Patentansprüche

1. Verfahren zum Herstellen einer nichtflüchtigen, mikroelektronischen Speichervorrichtung, die mit Transistoren mit angefügten Gates versehen ist, wobei das Verfahren die nachfolgenden Schritte umfasst:
- Bilden einer Schicht aus Diblockcopolymer über einer Schicht auf Basis eines ersten Gate-Materials (109), das auf einem Träger aufliegt,
- selektives Entfernen von Blöcken (116) auf Basis eines Polymers (117) des Copolymers in der Diblockpolymerschicht, so dass Muster (114) beibehalten werden, die um einen gegebenen Abstand (l₂) voneinander getrennt sind, wobei die Muster (114) auf Basis eines weiteren Polymers (115) des Copolymers bestehen, gefolgt von den nachfolgenden Schritten:
a) Bilden von zumindest einem ersten Gate-Transistor-Block (110a) und von zumindest einem Opferblock (110b) durch Ätzen der Schicht des ersten Gate-Materials durch die Muster (114) hindurch, wobei der erste Block (110a) und der Opferblock (110b) durch einen gegebenen Raum voneinander getrennt sind,
b) Bilden von zumindest einer Isolierschicht (121 - 122 - 123) und von einem zweiten Gate-Material (129) in dem gegebenen Raum, wobei das zweite Gate-Material in dem Raum einen weiteren Gate-Block (130a) bildet, der durch die Isolierschicht vom ersten Block (110a) getrennt ist, dann
- Bilden einer Maske (133), welche den ersten Gate-Block (110a) und einen Teil des Opferblocks (110b) bedeckt, wobei die Maske einerseits aus dem ersten Block (110a) hergestellt ist, so dass sie den weiteren Gate-Block (130a) bedeckt, und andererseits aus dem ersten Block (110a) so hergestellt ist, dass sie vom ersten Block (110a) übersteht, insbesondere über eine Überstandslänge, die geringer als der gegebene Abstand (l₂) ist,
- aufeinanderfolgendes Ätzen des zweiten Gate-Materials (129) und der Isolierschicht durch die Maske (133) hindurch,
c) Beseitigen des Opferblocks (110c) durch Ätzen durch die Maske (133) hindurch.

2. Verfahren nach Anspruch 1, wobei die Schicht auf Basis des ersten Gate-Materials (109) auf einer Schicht (107) aus Gate-Dielektrikum aufliegt, das auf dem Träger aufliegt, wobei die Schicht (113) aus Diblockcopolymer auf einer harten Maskenschicht (113) gebildet ist, die auf der Schicht auf Basis des ersten Gate-Materials (109) aufliegt, wobei das Ätzen in Schritt a) durch die harte Maske hindurch erfolgt, wobei das Verfahren ferner zwischen dem Schritt a) und dem Schritt b) das Entfernen der Schicht (107) aus Gate-Dielektrikum zwischen dem ersten Block und dem Opferblock durch Ätzen durch die harte Maske hindurch umfasst.

3. Verfahren nach einem der Ansprüche 1 oder 2, wobei die Muster quaderförmig sind.

4. Verfahren nach einem der Ansprüche 1 bis 3, wobei das Diblockcopolymer ausgewählt ist aus einem der nachfolgenden Materialien: PS-b-PMMA, PS-b-PI.

5. Verfahren nach einem der Ansprüche 1 bis 4, wobei die Isolierschicht (121 - 122 - 123) aus einer Stapelung gebildet ist, die enthält:
- zumindest eine erste Schicht (121) aus dielektrischem Material,
- zumindest eine Speicherschicht (122) zum Speichern von Ladungen, die auf der ersten Schicht aus dielektrischem Material gebildet ist,
- zumindest eine zweite Schicht (123) aus dielektrischem Material, die auf der Ladungsspeicherschicht gebildet ist.

6. Verfahren nach Anspruch 5, wobei der Schritt b) die nachfolgenden Schritte umfasst:
- angemessenes Aufbringen der Isolierschicht (121 - 122 - 123) auf die Blöcke (110a, 110b) des ersten Gate-Materials,
- Aufbringen des zweiten Gate-Materials (129) derart, dass der gegebene Raum verfüllt wird.

7. Verfahren nach Anspruch 6, ferner umfassend nach dem Schritt c) die nachfolgenden Schritte:
- Entfernen der Maske (133),
- teilweises Entfernen der Isolierschicht (121 - 122 - 123), wobei die Isolierschicht zwischen dem ersten Block, (110a) und dem weiteren Gate-Block (130a) und unter dem weiteren Gate-Block (130a) beibehalten wird.

8. Verfahren nach einem der Ansprüche 1 bis 7, wobei der Träger einen Halbleiterbereich (101) aufweist, in welchem die Kanäle der Transistoren vorgesehen sind, wobei der Halbleiterbereich mit einem Bereich aus Gate-Dielektrikum (107) und dann mit der Schicht aus dem ersten Gate-Material (109) bedeckt ist.

9. Verfahren nach Anspruch 8, wobei der Bereich aus Gate-Dielektrikum (107) und die Schicht aus dem ersten Gate-Material (109) in einer Vertiefung (103) ausgebildet sind, die in einer auf dem Träger aufliegenden Isolierschicht (102) ausgeführt ist.

10. Verfahren nach einem der Ansprüche 1 bis 9, wobei der Schritt a) das Bilden von zumindest einem zweiten Transistor-Gate-Block (110c) in der Schicht auf Basis des auf dem Träger aufliegenden ersten Gate-Materials (109) umfasst, wobei der zweite Block (110c) und der Opferblock (110b) durch einen weiteren gegebenen Raum voneinander getrennt sind, wobei der Opferblock (110b) zwischen dem ersten Block (110a) und dem zweiten Gate-Block (110c) liegt,
wobei der Schritt b) das Bilden der Stapelung, welche die Isolierschicht (121 - 122 - 123) und das zweite Gate-Material (129) aufweist, in dem weiteren gegebenen Raum umfasst, welche Stapelung wobei das in dem weiteren Raum befindliche Gate-Material einen Gate-Block (130c) bildet, der an den zweiten Block (110c) angefügt ist und durch die Isolierschicht von dem zweiten Block (110c) getrennt ist.

11. Verfahren nach Anspruch 10, wobei der weitere an den ersten Gate-Block (110a) angefügte Gate-Block (130a) ein Gate-Block eines ersten Speicher-Transistors ist, wobei der an den zweiten Gate-Block (110c) angefügte Gate-Block (130c) ein Gate-Block eines zweiten Speicher-Transistors ist und neben dem weiteren Gate-Block (130a) angeordnet ist, wobei das Verfahren ferner das Bilden eines gemeinsamen Kontaktbereichs zwischen dem ersten Speicher-Transistor und dem zweiten Speicher-Transistor umfasst.

## Claims

1. A method for making a micro-electronic non-volatile memory device provided with transistors having gates placed side by side, the method comprising the steps of:
- forming a diblock copolymer layer above the layer based on said first gate material (109) lying on a support,
- selectively removing in the diblock copolymer layer, blocks (116) based on a polymer (117) of said copolymer, so as to retain patterns (114) separated by a given distance, said patterns (114) being based on another polymer (115) of said copolymer, the method further comprising the steps of:
a) forming, by etching said first gate material through said patterns (114), of at least one first transistor gate block (110a) and at least one sacrificial block (110b), said first block (110a) and said sacrificial block (110b) being separated by a given space (l₂),
b) forming in said given space at least one insulating layer (121-122-123) and a second gate material (129), said second gate material in said space forming another gate block (130a) separated from the first block (110a) by said insulating layer,
- formation of a mask (133) covering said first gate block (110a) and said a part of said sacrificial block (110b), the mask being formed to cover part of the sacrificial block on one side of the first gate block and extending beyond another side of the first gate block, in particular of a length that is less than the given distance (l₂)
- successive etchings through said mask, of the second gate material, the insulating layer,
c) suppressing said sacrificial block, the sacrificial block being removed by etching through said mask,

2. The method according to claim 1, wherein the layer based on the first gate material (109) may be formed on a gate dielectric layer (107) formed on said support, the diblock copolymer (113) layer being formed on a hard mask layer formed on said first gate material layer, the etching in step a) being realized through said hard mask, the method further comprising: between step a) and step b), withdrawal of the gate dielectric layer (107) between the first block and said sacrificial block by etching through said hard mask.

3. The method according to any of claims 1 or 2: the given pattern and said other given pattern being parallelepipedal.

4. The method according to any of claims 1 to 3, the diblock copolymer being selected from one of the following materials: PS-b-PMMA, PS-b-PI.

5. The method according to any of claims 1 to 4, wherein said insulating layer (121-122-123) is formed with a stack comprising:
- at least one first dielectric material layer (121),
- at least one layer for storing charges (122) formed on said first dielectric material layer,
- at least one second dielectric material layer (123) formed on said charge storage layer.

6. The method according to claim 5, wherein step b) comprises steps for:
- conformable deposition of said insulating layer (121-122-123) on said blocks (110a, 110b) of said first gate material,
- deposition of said second gate material (129) so as to fill said given space.

7. The method according to claim 6, further comprising, after step c), the steps for:
- removing the mask (133),
- partially removing the insulating layer (121-122-123), the insulating layer being retained between said first gate block (110a) and said other gate block (130a) and under said other gate block (130a).

8. The method according to any of claims 1 to 7, wherein said support comprises a semiconducting area (101) in which the channels of said transistors are provided, the semiconducting area being covered with a gate dielectric area, and then with said layer of said first gate material (109).

9. The method according to claim 8, wherein the dielectric gate area (107), said layer of said first gate material (109) are formed in a cavity made in an insulating layer (102) lying on the support.

10. The method according to any of claims 1 to 9, step a) comprising the formation in said layer based on said first gate material (109) lying on said support, of at least one second transistor gate block (110c), said second block and said sacrificial block (110b) being separated by another given space, said sacrificial block being located between said first block and said second gate block, step b) comprising the formation in said other given space of said stack comprising said insulating layer (121-122-123) and said second gate material (129), said gate material located in said other space forming a gate block (130c) adjacent to said second block (110c) and separated from said second block (110c) by said insulating layer.

11. The method according to claim 10, wherein said other gate block (130a) adjacent to the first gate block (110a) is a gate block of a first memory storage transistor, said gate block (130c) adjacent to the second gate block (110c) is a gate block of a second memory storage transistor and is juxtaposed to said other gate block (130a), the method further comprising the formation of a common contact area between the first memory storage transistor and said second memory storage transistor.
